# EUROPEAN PATENT APPLICATION

(11) **EP 1 956 119 A1**
(43) Date of publication of application: **13.08.2008**
(21) Application number: 06833890.4
(22) Date of filing: 27.11.2006
(51) Int. Cl.: C30B 29/06, C03B 20/00, C30B 15/10

(54) **QUARTZ GLASS CRUCIBLE, PROCESS FOR PRODUCING THE SAME, AND USE**

(30) Priority: 29.11.2005 JP 2005344172
(71) Applicant: Japan Super Quartz Corporation, Akita-shi, Akita-ken 010-0065 (JP)
(72) Inventor: KANDA, Minoru, Akita-shi, Akita, 010-0065 (JP); SATO, Masaru, Akita-shi, Akita, 010-0065 (JP)
(74) Representative: HOFFMANN EITLE
(86) International application number: PCT/JP2006/324120
(87) International publication number: WO 2007/063996

(57) **Abstract**

A crucible has a structure where a layer containing a crystallization accelerating component such as aluminum or the like (a crystallization accelerating layer) is inserted inside a quartz glass layer of a crucible straight body part excepting a crucible bottom part. The crucible does not deform and fall inwardly at the straight body part since a part containing a crystallization accelerating component advances to crystallize so as to increase strength at a high temperature when the crucible is used in pulling up silicon single crystal. Therefore, a single crystallization rate can be increased. Further, since the crystallization accelerating layer is inserted inside the quartz glass layer, the crystallization accelerating component, such as aluminum or barium, does not contact with silicon melt or a carbon susceptor, contamination by eluting these metals does not occurs. Further, since the crystallization accelerating layer is not provided at the crucible bottom part, there is no danger to crack due to thermal distortion at a time of pulling up silicon single crystal and melt leakage does not occur.

## Description

### Field of the invention

The present invention relates to a quartz glass crucible used for pulling up silicon single crystal. More particularly, the present invention relates to the quartz glass crucible having excellent mechanical strength, almost no generation of a dislocation in an early stage of pulling up silicon single crystal, and high single crystallization rate.

### Description of the conventional art

When the silicon single crystal is pulled up, the quartz glass crucible is generally used. The quartz glass crucible has been conventionally improved many times in order to increase silicon single crystallization yield. For example, as for the quartz glass crucible used most generally, it is known that the following crucible is used. That is, a crucible having a double structure, where the inner surface of the crucible is formed with a transparent quartz glass layer, which does not contain bubbles substantially, and the outer surface of the crucible is formed with an opaque quartz glass layer containing much bubbles (Japanese Patent Application Laid Open No. 01(1989)-197381, and Japanese Patent Application Laid Open No. 01(1989)-197382). This quartz glass crucible has an advantage that dislocation is not generated by bursting the bubbles, since the inner surface of the crucible hardly contains the bubbles. However, when the silicon single crystal is pulled up, an oxygen deficiency type ring-like cristobalite crystal, which is called as a brown ring, is formed on the transparent quartz glass layer of the inner surface, so that there is a problem that the single crystallization rate is decreased due to peeling of the brown ring, which is caused by deforming the crucible when the crucible is used at a high temperature.

In order to solve the above-described problem, the following quartz glass crucibles have been known. That is, a quartz glass crucible formed by coating a component for accelerating crystallization (hereinafter, it is said to as a crystallization accelerator), such as barium, aluminum or the like, on an inner surface of the crucible, and uniformly forming a quartz crystalline layer on the inner surface of the crucible when a temperature increases for pulling up so as to prevent generating the brown ring. In this coated crucible, strength of the crucible also increases at a high temperature by forming the crystalline layer (Japanese Patent Application Laid Open No. 09(1997)-110590 and Japanese Patent Application Laid Open No. 08(1996)-2932). Further, a quartz crucible, where the crystallization accelerator is contained in the bubbles layer, is known (Japanese Patent Application Laid Open No. 11(1999)-171571). Further, a quartz glass crucible, where the crystallization accelerator is distributed in an inner layer of the crucible contacted with a silicon melt, or in a bulk layer of an outer wall of the crucible, is known (Japanese Patent Application Laid Open No. 2003-95678). Furthermore, the following quartz glass crucible has been also proposed, that is, a quartz glass crucible, where viscosity at a high temperature is increased by using a raw material quartz powder having high aluminum content to the whole outer surface of the quartz glass crucible (Japanese Patent Application Laid Open No. 2000-247778).

However, as for a quartz glass crucible having a crystalline layer formed by coating the crystallization accelerator on an inner surface of the crucible, there are problems that many dislocations generates in an early stage of pulling up since the crystallization accelerator is mixed into the silicon melt, and the crystallized layer is un-uniform or is easily peeled off. Further, although the crystallization accelerator is contained in the inner layer of the crucible, it cannot be avoided to mix the crystallization accelerator into the silicon melt although a mixing content of this accelerator to the silicon melt is lower than that of the crucible where the this accelerator is coated on the inner surface.

On the other hand, as for the quartz glass crucible where the crystallization accelerator is contained in an outer layer of the crucible (the bubble containing layer), although the outer layer is crystallized so as to increase strength of the crucible, the effect for crystallizing the inner surface of the crucible is poor. Further, as for the quartz glass crucible where the raw material quartz powder having high aluminum content, which is the crystallization accelerator, is used to the outer surface of the quartz crucible, there are following problems. That is, since the outer surface of the crucible is contacted with a container made by carbon (a susceptor) which supports the crucible, the carbon susceptor is contaminated by aluminum so that the consumption of the susceptor is remarkably increased. Further, the whole outer surface of the quartz glass crucible is crystallized, so that a difference of thermal expansion coefficients between the inner surface and the outer surface of the crucible becomes large when a residual liquid of silicon remained at the crucible bottom part is solidified at the time of finishing pulling up. Thus, the crucible bottom part is easily broken to cause melt leakage. Furthermore, since these thermal expansion coefficients are largely different, the crucible is easily cracked, so that contamination inside a furnace by aluminum may be enlarged in the furnace.

Further, it is known that a quartz glass crucible having a structure in which a layer containing the crystallization accelerator is formed between the outer layer and the inner layer of the crucible (Japanese Patent Application Laid Open No. 11(1999)-171684). However, as for the conventionally known crucibles, the layer containing the crystallization accelerator is formed at the whole crucible from a straight body part to a bottom part of the crucible, and this layer contains the crystallization accelerator, so that the thermal expansion coefficients of the outer layer and the inner layer on the both sides of the crucible are different. Therefore, when the layer containing the crystallization accelerator is formed on the crucible bottom part, since a molten silicon is remained at the crucible bottom part, there are problems that the crucible bottom part is cracked due to a thermal distortion at the time of finishing pulling up so as to cause the melt leakage.

### Summary of the Invention

The present invention solves the above-described conventional problems, and an objective of the present invention is to provide the quartz glass crucible, in which the mechanical strength is increased by accelerating crystallization of a peripheral wall of the crucible, a dislocation is not substantially generated in the early stage of pulling up, and the carbon susceptor is not contaminated, when the crucible is used for pulling up silicon single crystal at a high temperature.

The following crucibles are provided, that is,
(1) A quartz glass crucible used for pulling up silicon single crystal, wherein the crucible has a structure where a layer containing a crystallization accelerating component (a crystallization accelerating layer) is inserted between an inner layer and an outer layer of a crucible straight body part except a crucible bottom part, and any crystallization accelerating layers are not formed at the crucible bottom part.
   Since the quartz glass crucible of the present invention has a structure where the layer containing the crystallization accelerating component (the crystallization accelerating layer) is inserted between the inner layer and the outer layer of the crucible at the crucible straight body part except the crucible bottom part, the portion of the straight body, where the layer containing the crystallization accelerating component (the crystallization accelerating layer) is inserted, is advanced to crystallize by aluminum, or the like, so as to increase the crucible strength at the time of pulling up silicon single crystal, and thus deformation and inward falling of the straight body part hardly occurs. Therefore, the single crystallization rate increased. Further, the crystallization accelerating layer is inserted inside of the quartz glass layer and not coated on the surface of the crucible. Thus, the crystallization accelerating components, such as aluminum or barium, do not directly contact with the silicon melt or the carbon susceptor and are not melted into the silicon melt to contaminate. Further, since the crystallization accelerating layer is not provided on the bottom portion of the crucible, a crack due to a thermal distortion does not occur at an end time of pulling up and a melt leakage hardly occurs.
(2) The quartz glass crucible according to above (1), wherein a thermal expansion coefficient of each part of the crucible is preferably 8 % or less and a difference of thermal expansion coefficients between each part of the crucible is preferable 5.5 % or less under a standard heating condition. By taking the thermal expansion coefficient of each part of the crucible being 8 % or less and the difference of thermal expansion coefficients between each part of the crucible being 5.5 % or less, the crack due to a thermal distortion does not occurs at not only the bottom part of the crucible but also the whole of the crucible, so that the crucible can be used safely for long time.
(3) The quartz glass crucible according to above (1) and (2), wherein a part having the crystallization accelerating layer preferably has the range of more than 5% of a length of the crucible straight body part, except the crucible bottom part. When the length of the part having the crystallization accelerating layer is 5 % or less of the length of the crucible straight body part, a sufficient effect can not be obtained.
(4) The quartz glass crucible according to any one of above (1), (2), or (3), wherein a part having the crystallization accelerating layer is not provided at the bottom part of the crucible and a range of the crucible straight body part which is 5 mm to 30 mm from an upper end of the crucible and provided from the not provided range of the crucible straight part to a liquid surface level of the crucible straight part where the silicon melt is remained after pulling up. Since a crack easily occurs at the upper end of the crucible, it is preferable to insert the crystallization accelerating layer into the crucible straight body part excepting the above described part which is 5 mm to 30 mm from the upper end of the crucible.
(5) The quartz glass crucible according to any one of above (1) to (4), wherein a thickness of the crystallization accelerating layer is 1 mm or more, quartz glass layers having the thickness of 2 mm or more are formed on the both sides of the crystallization accelerating layer, and an inner surface of the crucible is formed of a transparent quartz glass layer having a thickness of 0.5 mm or more.
(6) The quartz glass crucible according to any one of above (1) to (5), wherein the crucible preferably contains 50 to 500 ppm aluminum or an alkaline earth metal as a crystallization accelerating component.
(7) A production method of the quartz glass crucible produced by heating and melting a quartz powder stored on an inner surface of a rotary mold, and the method including the steps of;
   forming a quartz powder layer part containing the crystallization accelerating component inside a quartz powder layer forming the crucible straight body part;
   integrally heating and melting these quartz powder layers so as to vitrify those; and
   forming a structure where the crystallization accelerating layer is inserted inside the quartz glass layer of the crucible straight body part except the crucible bottom part.
(8) A production method of the quartz glass crucible according to (7), the method further including the steps of;
   forming the quartz powder layer part containing the crystallization accelerating component, inside the quartz powder layer of the crucible straight body part;
   heating these quartz powder layers at a temperature of 1800 degree C or more for 5 minutes or more;
   introducing helium gas, hydrogen gas, or steam into an apparatus at least a part of heating time so as to vitrify these quartz powders; and
   sucking the quartz powder layer into a reduced pressure so as to control a bubble content in a wall thickness direction of the crucible to 0.05% or more to 0.8% or less.
(9) A method for accelerating a crystallization of the quartz glass in the crystallization accelerating layer, wherein the quartz glass crucible according to any one of above (1) to (6) is used in a process of pulling up a silicon single crystal.

### [Brief explanation of drawings]

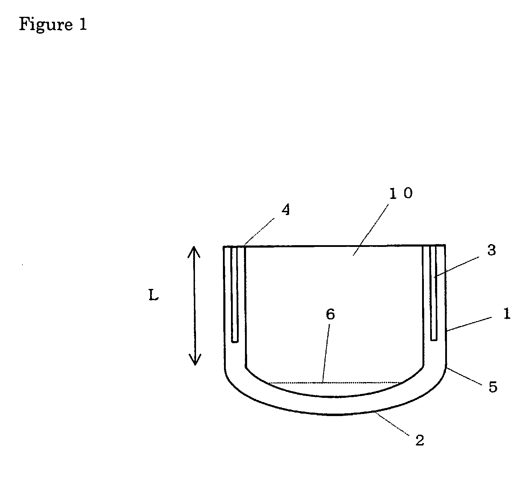

Figure 1 is a cross sectional view of a quartz glass crucible according to the present invention.

### [Detailed description of the preferred embodiment]

The quartz glass crucible of the present invention is a quartz glass crucible used for pulling up a silicon single crystal. This quartz glass crucible has a structure where a layer containing the crystallization accelerating component (a crystallization accelerating layer) is inserted between an inner layer and an outer layer of the crucible straight body part except a crucible bottom part, and not formed at the crucible bottom part.

As for a conventional quartz glass crucible, a cause of dislocation generation in many times at an early stage of pulling up silicon single crystal has been searched. Then, in addition to the general causes, it was found out that dislocation generation in many times is influenced with deforming or inclining inside of the peripheral wall of the crucible straight body part, which is positioned at an upper part from the silicon melt surface. Therefore, if the glass layer of this range is crystallized, strength of a peripheral wall at a high temperature is increased and thermal deformation or inward falling can be prevented, so that dislocation generation can be controlled.

As a method for crystallizing, it is conventionally known that a method includes the steps of coating an alkaline earth metal such as barium on a surface of the glass layer and crystallizing the glass layer by thermal diffusion at the high temperature. However, when barium or the like is coated on an inner surface of the crucible, barium is eluted into the silicon melt so as to cause many dislocations. On the other hand, when barium is coated on the outer surface of the crucible, the coated surface is contacted with the carbon susceptor so as to contaminate the susceptor.

The quartz glass crucible of the present invention is formed to have a structure, where a quartz glass layer containing the crystallization accelerating component (a crystallization accelerating layer) is inserted inside a quartz glass layer of the crucible straight body part except the crucible bottom part. Thus, since a part having the crystallization accelerating layer is accelerated to crystallize, strength of this part at a high temperature increases so as to prevent the thermal deformation or the inward falling of the peripheral wall of the crucible. On the other hand, since the crystallization accelerating layer is inserted between an inner layer of the crucible (a quartz glass part on an inner surface side) and an outer layer of the crucible (a quartz glass part on an outer surface side), this layer is not contacted with a silicon melt. Therefore, the crystallization accelerating component does not elute into the silicon melt and not contacted with the carbon susceptor, so that the susceptor is not contaminated.

A range of forming the crystallization accelerating layer is a crucible straight body part 1 of a crucible 10 except a bottom part 2, as illustrated in Figure 1. A crystallization accelerating layer 3 is not formed at the crucible bottom part 2. More particularly, for example, a range of the crystallization accelerating layer is from an upper end 4 of the crucible to more than 5% of a length L of the crucible straight body part except the crucible bottom part. Generally, the range may be from the crucible upper end 4 to a bent position 5 extending to the crucible bottom part, and mostly a range being from the crucible upper end 4 to a liquid surface level 6 where the silicon melt is remained.

As for the crucible of the present invention, basically, forming the crystallization accelerating layer includes until that the upper end of this layer reaches to the crucible upper end. However, it is preferable that forming the crystallization is stopped at a little lower position from the crucible upper end. If the crystallization accelerating layer is formed until to the crucible upper end part, a crack easily causes from the crucible upper end part by thermal distortion, so that these layers are easily peeled off. As a result of this, the single crystallization rate is decreased by the peeled piece. Thus, it is preferable that the crystallization accelerating layer is not formed within a range of at least 5 mm from the crucible upper end, and generally the range is about 30 mm from the crucible upper end. When the upper end of the crystallization accelerating layer is formed at the lower position from the crucible upper end, the crystallization accelerating layer has a structure where both of the upper end side and the crucible bottom part side are covered with the quartz glass layer, that is, the quartz glass layer is formed around the crystallization accelerating layer. Thus, the peeling off of these layers can be prevented.

The crystallization accelerating layer 3 is not formed at the crucible bottom part 2 including the bent portion 5 of the crucible. If the crystallization accelerating layer is formed at the crucible bottom part, the crucible is cracked by a thermal distortion at the time of finishing pulling up, and danger of the melt leakage can be prevented.

As a crystallization accelerating component, aluminum, an alkaline earth metal or the like is used. It is preferable that a content of the crystallization accelerating component is 50 to 500 ppm and a thickness of the crystallization accelerating layer is 1 mm or more. If the content of the crystallization accelerating component is less than 50 ppm, the crystallization of the quartz glass of the crystallization accelerating layer is insufficient. Further, if the thickness of the crystallization accelerating layer is thinner than 1 mm, the crystallization layer can not support an inner layer and an outer layer of the crucible on the both sides of the crystallization accelerating layer when these layers are softened at a high temperature, even when the crystallization at a part of the crystallization accelerating layer is accelerated. So, it cannot be fully prevented to cause a shape failure. In addition, if the content of the crystallization accelerating component is more than 500 ppm, alkaline earth metal may be diffused to an inner crucible surface by thermal diffusion at a time of using the crucible so as to be mixed into the silicon melt.

It is suitable that thicknesses of the inner and the outer layer of the crucible on the both sides of the crystallization accelerating layer are 2 mm or more, and preferably 3 mm or more. If the thicknesses of the inner and the outer layer of the crucible are thinner than 2 mm, alkaline earth metal or the like may pass through these quartz glass layers and diffuse to the inner and outer surface of the crucible.

Furthermore, as for the quartz glass crucible having the structure where the crystallization accelerating layer is inserted, it is preferable that an expansion coefficient of each portion of the crucible under a standard heating condition is 8% or less, and difference between the expansion coefficients of each portion of the crucible is 5.5% or less. As for the crucible having such a structure where the thermal expansion is controlled, even when thermal load is applied by pulling up for a long period of time, the glass layer and the crystallization layer are not cracked and peeled, so that the high single crystallization rate can be obtained. In addition, the standard heating condition is that heating is carried out at 1500 degree C under 20 torr of an argon atmosphere for 10 hours.

If the expansion coefficient of each portion of the crucible under the standard heating condition is more than 8%, a crack easily generates between the glass layer and the crystallization layer since the expansion coefficient of the crystallization layer is comparatively low. In addition, it is preferable that the expansion coefficient is 7.5% or less, and more preferably 7% or less. Further, if the difference between the expansion coefficients of each portion of the crucible is more than 5.5%, the distortion by thermal expansion increases, so that the crystallization layer is easily peeled off. Therefore, it is preferable that the difference between the expansion coefficients of each portion of the crucible is 5.5% or less. In addition, it is more preferable that this difference between the expansion coefficients is 5% or less.

The quartz glass crucible of the present invention can be produced by the method for producing the quartz glass crucible by heating and melting the quartz powders stored at an inner surface of the rotary mold. This method including the steps of forming a quartz powder layer portion, which contains the crystallization accelerating component, inside the quartz powder layer forming the crucible straight body part; integrally heating and melting the quartz powder layer to vitrify; and cooling it immediately. More particularly, for example, this method including the steps of storing general quartz powders for forming the crucible outer layer at an inner surface of the rotary mold; storing general quartz powders at the crucible bottom part; storing quartz powers containing about 50 to 500 ppm of the crystallization accelerating component on the general quartz powders at the crucible straight body part; storing general quartz powders for forming the crucible inner layer on the quartz powders containing the crystallization accelerating component; integrally melting these quartz powders by arc heating to vitrify; and cooling those. In addition, by sucking the quartz powder storing layer from inner side of the mold at the time of heating and melting, a transparent quartz glass layer can be formed, where the crucible inner surface portion does not contain the bubbles substantially.

In the above-described production method, the quartz powders stored at the inner surface of the mold are heated at about 1800 degree C to vitrify. However, since time for heating and melting is about 20 minutes and the quartz powders are cooled at a room temperature immediately after vitrification, crystallization by aluminum or barium is not advanced. In addition, pulling up the silicon single crystal is carried out for a long time being from tens hours to about 100 hours at a melting temperature of silicon, according to a charge amount of the silicon melt. Thus, the crucible is applied remarkably larger thermal load than that at the time of producing the crucible. By this thermal load, the quartz glass of the crystallization accelerating layer is accelerated to be crystallized, and strength of the crucible at a high temperature can be increased.

Further, the quartz glass crucible having an expansion coefficient of each portion under the standard heating condition of 8% or less and difference between the expansion coefficients of each crucible portion of 5.5% or less can be produced as following processes when the quartz powders stored at the inner surface of the mold are integrally heated and melted in the rotary mold method. That is, the crucible can be produced by the steps of heating the quartz powders stored at the inner surface of the mold, introducing helium gas, hydrogen gas, or steam into an apparatus at least a part of a time of heating to be vitrified, and sucking the quartz powder layer into a reduced pressure so as to control bubbles content in a wall thickness direction of the crucible to 0.05% or more to 0.8% or less.

When a heating temperature of the quartz powder layer is 1800 degree C or less and a heating time is less than 5 minutes, the replacement of air to above these gases in the quartz powder layer is insufficient when helium gas, hydrogen gas or steam is introduced at the melting condition to vitrify the quartz powders. Further, when bubbles content in the wall thickness direction of the crucible is more than 0.8%, expansion of these bubbles becomes large. Thus, in the both cases, the expansion coefficient of the wall thickness of the crucible cannot be controlled to less than objective value. In addition, it is preferable that the crucible outer wall part contains about 0.05% bubbles in order to obtain a thermal diffusion effect by the bubbles.

The quartz glass crucible of the present invention can also be produced by a method depositing the melted quartz powders at an inner surface of the rotary mold. In addition, the present invention includes a method, where the quartz glass crucible according to the present invention is used in a process of pulling up a silicon single crystal and the crystallization at the crucible straight body part is accelerated by the crystallization accelerating component contained in the crucible straight body part.

### [Example and comparison example]

Hereinafter, the present invention is described concretely with examples and comparison examples. In addition, in all examples, a quartz crucible, which has a diameter of 24 inch, length of a straight body part of 300 mm and the whole wall thickness from the inner surface to the outer surface of the crucible of 10 mm, was used as a sample crucible. Further, a silicon melt was filled to 300 mm in height of each quartz glass crucible, and a silicon single crystal was pulled up at 1500 degree C (a pulling up time was 100 hours). Here, a sinking amount was a reducing amount of the height of the crucible after pulling up.

As for the quartz glass crucible having the crystallization accelerating layer illustrated in Table 1, crucible shapes after pulling up the silicon single crystal were observed. These results were shown collectively in Table 1. In addition, the shapes of each crucible were as follows.

As for all of samples of the present invention A1 to A5, since the crystallization accelerating layer was crystallized when the sample was used at the time of pulling up, the strength of the crucible was increased, there was no inward falling in the crucible upper part, and the sinking amount was slight. Further, aluminum was not diffused to the inner layer and the outer layer on the both side of the crystallization accelerating layer, and the devitrification of the outer surface by the crystallization and aluminum contamination were not generated. Furthermore, as for samples of the present invention A6 and A7, since the crucible has a part which not contains the crystallization accelerating layer and is formed at the crucible upper end part, the upper end surface part was not peeled off.

Comparison sample B1: Aluminum was diffused to the surface of the quartz glass layer on the outer peripheral side at the time of pulling up, and a part of the outer surface was crystallized to be devitrified. Therefore, the outer surface may be cracked at the time of cooling after finishing pulling up silicon single crystal and generate contamination by melt leakage.

Comparison sample B2: Since aluminum was diffused to the inner surface crucible of the crucible to be contaminated at the time of pulling up, the inner surface of the crucible was partially devitrified during pulling up. Thus, the silicon single crystallization rate (Si yield) was low.

Comparison sample B3: Since the aluminum content was low such as 30 ppm, the crystallization accelerating layer was not fully crystallized, so that strength of the wall part was not fully increased. Therefore, the crucible upper part was deformed and fallen inwardly at the time of pulling up. Thus, the silicon yield was low.

Comparison sample B4: Since the length in the vertical direction was 5% or less of the length of the crucible straight body part, the strength of the wall part was not fully increased. Thereby, the crucible upper part was deformed or fallen inwardly at the time of pulling up. Thus, the silicon yield was low.

**[Table 1]**

| | Distance (mm) | A1 | A2 | A3 | A4 | A5 | A6 | A7 | B1 | B2 | B3 | B4 |
|---|---|---|---|---|---|---|---|---|---|---|---|---|
| Al Concentration (ppm) | 0-1 | 8 | 8 | 8 | 8 | 8 | 8 | 8 | 8 | 20 | 8 | 8 |
| | 1-2 | 8 | 8 | 8 | 8 | 8 | 8 | 8 | 8 | 300 | 8 | 8 |
| | 2-4 | 8 | 8 | 8 | 8 | 8 | 8 | 8 | 8 | 300 | 8 | 8 |
| | 4-6 | 300 | 200 | 100 | 50 | 8 | 200 | 200 | 300 | 300 | 30 | 300 |
| | 6-8 | 8 | 8 | 8 | 8 | 300 | 8 | 8 | 300 | 8 | 8. | 8 |
| | 8-9 | 8 | 8 | 8 | 8 | 8 | 8 | 8 | 300 | 8 | 8 | 8 |
| | 9-10 | 8 | 8 | 8 | 8 | 8 | 8 | 8 | 8 | 8 | 8 | 8 |
| Thickness of Accelerating Crystallization Layer (mm) | | 2 | 2 | 2 | 1.5 | 2 | 2 | 2 | 5 | 5 | - | 2 |
| Existence of Crystallization Outer Surface | | No | No | No | No | No | No | No | A Part | No | No | No |
| Existence of Inward End ( Falling of Surface) Part | | No | No | No | No | No | No | No | No | No | Yes | No |
| Existence of End Feeling of Upper Part | | Yes | Yes | Yes | Yes | Yes | No | No | Yes | Yes | No | Yes |
| Sinking Amount (mm) | | 20 | 20 | 20 | 25 | 20 | 20 | 20 | 15 | 15 | 30 | 30 |
| Existence of Al Inner Contamination of Surface | | No | No | No | No | No | No | No | No | Yes | No | No |
| Range of Acceleration crystallization Layer (%) | | 15 | 40 | 60 | 30 | 15 | 40 | 40 | 15 | 15 | 15 | 5 |
| Distance Part of Accelerating Layer End between Upper End crystallization yer and Crucible surface (mm) | | 0 | 0 | 0 | 0 | 0 | 5 | 30 | 0 | 0 | 0 | 0 |
| Si Yield (%) | | 80 | 80 | 80 | 75 | 80 | 82 | 81 | 75 | 50 | 60 | 60 |

| | | | | | | | | | | | | |
|---|---|---|---|---|---|---|---|---|---|---|---|---|
| (Note) A1 to A7 are examples. B1 to B4 are comparison examples. A Part means a partially crystallization. Distance is a distance from the crucible inner surface to the crystallization accelerating layer. Range of Crystallization Accelerating Layer is a ratio of the crystallization accelerating layer to the length of the crucible straight body part | | | | | | | | | | | | |

### [Possibility of application for industry]

Since the quartz glass crucible of the present invention has the structure where the layer containing the crystallization accelerating component such as aluminum or the like is inserted in the crucible straight body part except the crucible bottom part, the part having the layer containing the crystallization accelerating component advances to be crystallized by aluminum or the like at the time of pulling up silicon single crystal, so that the crucible strength at a high temperature is increased. Thus, when the crucible is used, deformation or inward falling of the crucible straight body part does not generate. Therefore, a silicon single crystallization rate can be increased. Further, the crystallization accelerating layer is inserted inside the quartz glass layer and the crystallization accelerating component is not coated in the crucible surface. Thus, the crystallization accelerating component such as aluminum, barium or the like is not contacted with a silicon melt or a carbon susceptor, so that contamination by eluting these components can be prevented. Further, since the crystallization accelerating layer is not formed at the crucible bottom part, it can be prevented to generate cracking by thermal distortion at a time of finishing pulling up, so that leakage of silicon melt does not generate.

## Claims

1. A quartz glass crucible used for pulling up silicon single crystal, wherein the crucible has a structure in which a layer containing a crystallization accelerating component (a crystallization accelerating layer) is inserted between an inner layer and an outer layer of a crucible straight body part except a crucible bottom part, and the crystallization accelerating layer is not formed at the crucible bottom part.

2. The quartz glass crucible according to Claim 1, wherein a thermal expansion coefficient of each part of the crucible is 8 % or less under a standard heating condition and a difference of the thermal expansion coefficients between each part of the crucible is 5.5 % or less.

3. The quartz glass crucible according to Claim 1 or Claim 2, wherein a part having the crystallization accelerating layer has a range of more than 5% of a length of the crucible straight body part, except the crucible bottom part.

4. The quartz glass crucible according to any one of Claim 1 to Claim3, wherein a part having the crystallization accelerating layer is not provided at the bottom part of the crucible and a range of the crucible straight body part which is 5 mm to 30 mm from an upper end of the crucible and provided from the not provided range of the crucible straight part to a liquid surface level of the crucible straight part where the silicon melt is remained after pulling up.

5. The quartz glass crucible according to any one of Claim 1 to Claim4, wherein a thickness of the crystallization accelerating layer is 1 mm or more, quartz glass layers having a thickness of 2 mm or more are formed on both sides of the crystallization accelerating layer, and an inner surface of the crucible is formed with a transparent quartz glass layer having a thickness of 0.5 mm or more.

6. The quartz glass crucible according to any one of Claim 1 to Claim 5, wherein the crucible contains 50 to 500 ppm aluminum or an alkaline earth metal as the crystallization accelerating component.

7. A production method of the quartz glass crucible produced by heating and melting a quartz powder stored at an inner surface of a rotary mold, the method comprising the steps of;
forming a quartz powder layer part containing the crystallization accelerating component inside a quartz powder layer for forming the crucible straight body part;
integrally heating and melting these quartz powder layers so as to vitrify those; and
forming a structure where the crystallization accelerating layer is inserted inside a quartz glass layer of the crucible straight body part except the crucible bottom part.

8. A production method of the quartz glass crucible according to Claim 7, the method comprising the steps of;
forming the quartz powder layer part containing the crystallization accelerating component inside the quartz powder layer of the crucible straight body part;
heating these quartz powder layer at 1800 degree C or more for 5 minutes or more;
introducing helium gas, hydrogen gas, or steam into an apparatus at least a part of time of heating so as to vitrify the quartz powders;
sucking the quartz powder layer into a reduced pressure so as to adjust a bubble content in a wall thickness direction of the crucible from 0.05% or more to 0.8% or less.

9. A method for accelerating the crystallization of the quartz glass of the crystallization accelerating layer, wherein the quartz glass crucible according to any one of claims 1 to 6 is used in a process of pulling up silicon single crystal.
